# EUROPEAN PATENT APPLICATION

(11) **EP 3 313 102 A1**
(43) Date of publication of application: **25.04.2018**
(21) Application number: 16306382.9
(22) Date of filing: 21.10.2016
(51) Int. Cl.: H04S 7/00, H04R 27/00

(54) **APPARATUS AND METHOD FOR INTELLIGENT AUDIO LEVELS FOR CAR, HOME OR PUBLIC ENTERTAINMENT**

(71) Applicant: Thomson Licensing, 92130 Issy-les-Moulineaux (FR)
(72) Inventor: DUONG, Quang Khanh Ngoc, 35576 Cesson-Sévigné (FR); ERIKSSON, Brian Charles, Los Altos, CA California 94022 (US); GILBERTON, Philippe, 35576 Cesson-Sévigné (FR); DELAUNAY, Christophe, 35576 Cesson-Sévigné (FR)
(74) Representative: Huchet, Anne

(57) **Abstract**

The present principles generally relate to audio apparatus, methods, and computer program products and in particular, to improvements that adjust the sound level or levels of one or more audio outputs of an audio system based on the determined origin and/or direction of propagation of a detected human voice in a location. Such an adjustment may be to decrease, mute, or increase the sound level of an audio output producing sound in the direction of the origin of the voice. A sound level produced by other audio outputs may be unchanged.

## Description

### TECHNICAL FIELD

The present principles generally relate to audio systems, methods, and computer program products, and in particular to an audio system which is able to automatically and selectively adjust the sound level of one or more audio outputs of the audio system based on the determined origin and/or direction of travel of a detected human voice inside a location. Such an adjustment may be to decrease, mute, or even increase the selected sound level.

### BACKGROUND

Audio systems are widely used in different locations such as at home, in a vehicle, or in a public theatre for projecting sound to an audience. They may be used as a part of, e.g., an entertainment system at home, or as a part of a radio, and/or a navigation system in a car.

US 2011/0218711 patent publication assigned to GM Global Technologies Operations, Inc., and filed in the names of Bhavna Mathur et al, describes an infotainment system for an automobile. The infotainment system includes a navigation system, an entertainment system, audio output device, a control system, and etc. The system further includes a human conversation recognizer that determines if a human conversation is being conducted. The control system of the infotainment system then lowers the output sound level of the audio output device in the event that a human conversation is being conducted.

### SUMMARY

The present inventors recognize that the existing audio systems such as the GM systems described above, however, do not provide effective and intelligent sound management and would need further improvements. For example, existing audio systems do not determine the location of the origin of and/or the direction of the human voice or conversation, and do not selectively control the one or more of the audio outputs typically found in today's multi-channel sound systems.

Accordingly, an exemplary apparatus is presented, comprising: a detector configured to detect an ambient noise in a location; one or more processors configured to determine from the detector whether the ambient noise includes a voice of a person in the location; and based on determining that the ambient noise includes the voice of the person in the location, further configured to determine an origin of the voice; and the one or more processors are further configured to enable an adjustment in a level of at least one sound output of a plurality of sound outputs of one or more audio output drivers, wherein the at least one sound output of the plurality of sound outputs being adjusted is projecting sound in a direction toward the determined origin of the voice.

In another exemplary embodiment, apparatus producing a sound output adjustment as described above may be configured to produce a sound output adjustment comprising one of decreasing and muting and increasing the sound output of the sound output projecting sound in the direction toward the determined origin of the voice.

In another exemplary embodiment, an exemplary apparatus is presented, comprising: a detector configured to detect an ambient noise in a location; one or more processors configured to determine from the detector whether the ambient noise includes a voice of a person in the location; and based on determining that the ambient noise includes the voice of the person in the location, further configured to determine an origin of the voice; and the one or more processors are further configured to enable a decrease in a level of at least one sound output of a plurality of sound outputs of one or more audio output drivers, wherein the at least one sound output of the plurality of sound outputs being decreased is projecting sound in a direction toward the determined origin of the voice.

In another exemplary embodiment, a method performed by an apparatus is presented, comprising: detecting, via a detector, an ambient noise in a location; determining from the detector, via one or more processors, whether the ambient noise includes a voice of a person in the location; if the ambient noise includes the voice of the person in the location based on the determining, determining an origin of the voice; and enabling an adjustment in a level of at least one sound output of a plurality of sound outputs of one or more audio output drivers of the apparatus, wherein the at least one sound output of the plurality of sound outputs being adjusted is projecting sound in a direction toward the determined origin of the voice.

In another exemplary embodiment, a method producing a sound output adjustment as described above comprises enabling an adjustment comprising one of decreasing and muting and increasing the sound output projecting sound in a direction toward the determined origin of the voice.

In another exemplary embodiment, a method performed by an apparatus is presented, comprising: detecting, via a detector, an ambient noise in a location; determining from the detector, via one or more processors, whether the ambient noise includes a voice of a person in the location; if the ambient noise includes the voice of the person in the location based on the determining, determining an origin of the voice; and enabling a decrease in a level of at least one sound output of a plurality of sound outputs of one or more audio output drivers of the apparatus, wherein the at least one sound output of the plurality of sound outputs being decreased is projecting sound in a direction toward the determined origin of the voice.

In another exemplary embodiment, a computer program product stored in a non-transitory computer-readable storage medium is presented, comprising computer-executable instructions for: detecting an ambient noise in a location; determining whether the ambient noise includes a voice of a person in the location; if the ambient noise includes the voice of the person in the location based on the determining, determining an origin of the voice; and enabling an adjustment in a level of at least one sound output of a plurality of sound outputs of one or more audio output drivers, wherein the at least one sound output of the plurality of sound outputs being adjusted is projecting sound in a direction toward the determined origin of the voice.

### BRIEF DESCRIPTION OF THE DRAWINGS

The above-mentioned and other features and advantages of the present principles, and the manner of attaining them, will become more apparent and the present invention will be better understood by reference to the following description of embodiments of the present principles taken in conjunction with the accompanying drawings, wherein:
- Fig. 1: shows an exemplary system according to the present principles;
- Fig. 2: shows an exemplary process according to the present principles;
- Fig. 3: shows another exemplary system according to the present principles.

The examples set out herein illustrate exemplary embodiments of the present principles. Such examples are not to be construed as limiting the scope of the present principles in any manner.

### DETAILED DESCRIPTION

The present principles recognize that e.g., human conversations in cars are often disturbed or interrupted by sounds from an audio system such as the sounds from the radio or the turn-by-turn navigation prompts from a GPS. Accordingly, the present inventors recognize that by using a detector comprising more than one microphone, the present principles may detect and determine both the origin and/or the direction of a human conversation or voice in a location such as inside a car or in a home theater room. Therefore, the exemplary embodiments of the present principles may intelligently adjust the one or more of the output audio levels of the multiple output channels of the audio system, in response to the detected voice. For example, a conversation between two individuals in the back seat of a car may result in the rear audio speakers being decreased in volume, while the front speakers may remain at the same audio levels. Accordingly, the present principles provide automatically adjustable and highly adaptive audio/sound systems and methods for people inside a car or in a room to more easily and clearly communicate with each other.

Accordingly, the present description illustrates the present principles. It will thus be appreciated that those skilled in the art will be able to devise various arrangements that, although not explicitly described or shown herein, embody the present principles and are included within its scope.

All examples and conditional language recited herein are intended for pedagogical purposes to aid the reader in understanding the present principles and the concepts contributed by the inventors to furthering the art, and are to be construed as being without limitation to such specifically recited examples and conditions.

Moreover, all statements herein reciting principles, aspects, and embodiments of the present principles, as well as specific examples thereof, are intended to encompass both structural and functional equivalents thereof. Additionally, it is intended that such equivalents include both currently known equivalents as well as equivalents developed in the future, i.e., any elements developed that perform the same function, regardless of structure.

Thus, for example, it will be appreciated by those skilled in the art that the block diagrams presented herein represent conceptual views of illustrative circuitry embodying the present principles. Similarly, it will be appreciated that any flow charts, flow diagrams, state transition diagrams, pseudocode, and the like represent various processes which may be substantially represented in non-transitory computer readable media and so executed by one or more computers, and/or one or more processors, whether or not such computer(s) or processor(s) is/are explicitly shown.

The functions of the various elements shown in the figures may be provided through the use of dedicated hardware as well as hardware capable of executing software in association with appropriate software. When provided by a processor, the functions may be provided by a single dedicated processor, by a single shared processor, or by a plurality of individual processors, some of which may be shared. Moreover, explicit use of the term "processor" or "controller" should not be construed to refer exclusively to hardware capable of executing software, and may implicitly include, without limitation, digital signal processor ("DSP") hardware, read-only memory ("ROM") for storing software, random access memory ("RAM"), and non-volatile storage.

Other hardware, conventional and/or custom, may also be included. Similarly, any switches shown in the figures are conceptual only. Their function may be carried out through the operation of program logic, through dedicated logic, through the interaction of program control and dedicated logic, or even manually, the particular technique being selectable by the implementer as more specifically understood from the context.

In the claims hereof, any element expressed as a means for performing a specified function is intended to encompass any way of performing that function including, for example, a) a combination of circuit elements that performs that function or b) software in any form, including, therefore, firmware, microcode or the like, combined with appropriate circuitry for executing that software to perform the function. The present principles as defined by such claims reside in the fact that the functionalities provided by the various recited means are combined and brought together in the manner which the claims call for. It is thus regarded that any means that can provide those functionalities are equivalent to those shown herein.

Reference in the specification to "one embodiment", "an embodiment", "an exemplary embodiment" of the present principles, or as well as other variations thereof, means that a particular feature, structure, characteristic, and so forth described in connection with the embodiment is included in at least one embodiment of the present principles. Thus, the appearances of the phrase "in one embodiment", "in an embodiment", "in an exemplary embodiment", or as well any other variations, appearing in various places throughout the specification are not necessarily all referring to the same embodiment.

It is to be appreciated that the use of any of the following "/", "and/or", and "at least one of", for example, in the cases of "A/B", "A and/or B" and "at least one of A and B", is intended to encompass the selection of the first listed option (A) only, or the selection of the second listed option (B) only, or the selection of both options (A and B). As a further example, in the cases of "A, B, and/or C" and "at least one of A, B, and C", such phrasing is intended to encompass the selection of the first listed option (A) only, or the selection of the second listed option (B) only, or the selection of the third listed option (C) only, or the selection of the first and the second listed options (A and B) only, or the selection of the first and third listed options (A and C) only, or the selection of the second and third listed options (B and C) only, or the selection of all three options (A and B and C). This may be extended, as readily apparent by one of ordinary skill in this and related arts, for as many items listed.

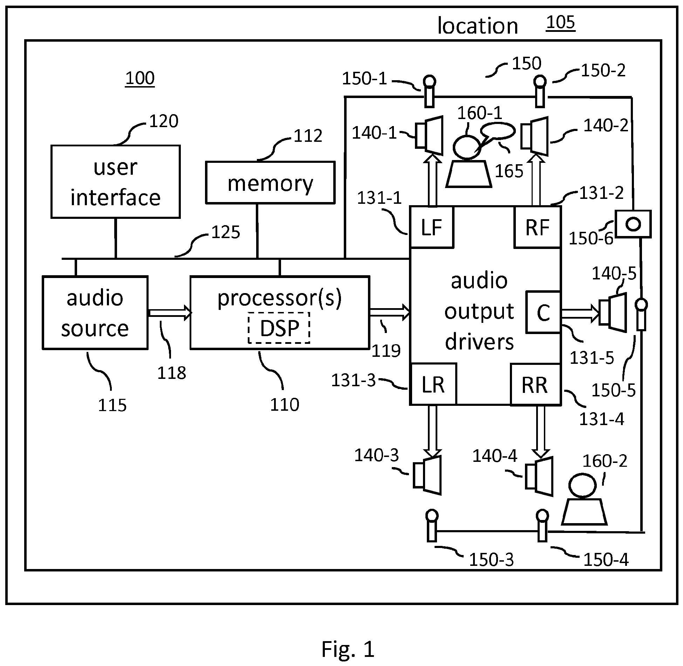

Fig. 1 shows an exemplary system 100 according to the present principles. The exemplary system 100 in Fig. 1 is an audio system which comprises a processor 110, a memory 112, an audio source 115, a user interface device 120, a plurality of audio output drivers 131-1 to 131-5, and a detector 150. According to the present principles, the audio source 115 shown in Fig. 1 may be, e.g., audio content from a CD, DVD, television program, radio program, internet streaming, cellphone, a GPS device, and etc. The audio content may be in a multi-channel format such as, e.g., stereo, Dolby 5.1, or the like, or a mono-channel format which may then be processed by the exemplary audio system 100 into multi-channel audio outputs. Also as shown in Fig. 1, the exemplary audio system 100 may be located in a location 105. Such a location may be, e.g., one of: 1) in a vehicle, 2) in a room, and 3) in a public theater. In addition, the audio system 100 may be a part of an apparatus, the apparatus may be, e.g. one of: 1) a home theater system, 2) a set top box, 3) a digital television, and 4) a computer.

The user interface device 120 in Fig. 1 may represent one type or different types of user input/output (I/O) devices such as, e.g., a knob or knobs, a keyboard (physical or virtual), a touch screen, and etc. The user interface 120 is configured to provide functions and operations for the user to interface and/or interact with the exemplary audio system 100, such as for inputting user selections and operations for the audio system, and for providing visual and/or audio indications and feedbacks to the user.

The exemplary audio system 100 shown in Fig. 1 also comprises a processor 110 for processing various data from the components of the audio system 100 and for controlling various functions and the components of the audio system 100. Processor 110 communicates with, obtains inputs from, and provides inputs to the various components of the audio system 100. The processor 110 communications with and controls the various components of the audio system 100 via a control and data bus 125 as shown in Fig. 1. Also, as already described above, processor 110 shown in Fig. 1 may represent one or more processors, since the number of the processors used for a particular audio system depends on the design and engineering requirements of the particular audio system, as well known by one skilled in the art. Also, processor 110 may process the data outputted from the detector 150 in order to determine the origin and/or the direction of travel of any voice or conversation which may be present in a location as to be described further below.

In addition, processor 110 shown in Fig. 1 may comprise a digital signal processor (DSP) and/or perform a digital signal processing (DSP) function. The DSP may be used to process the audio content from the audio source 115 via input 118 to the processor 110. Once the audio content from the audio source 115 is processed by processor 110, it is outputted to exemplary audio output drivers 131-1 to 131-5 shown in Fig. 1 for the multi-channel audio system 100. As shown in Fig. 1, five exemplary audio channel outputs are outputted by the corresponding five exemplary audio output drivers 131-1 to 131-5 as shown in Fig. 1. These five exemplary audio channel outputs are: Left Front (LF) audio channel driven by LF audio driver 131-1; Right Front (RF) audio channel driven by RF audio driver 131-2; Left Rear (LR) audio channel driven by LR audio driver 131-3; Right Rear (RR) audio channel driven by RR audio driver 131-4; and Center (C) audio channel driven by C audio driver 131-5. Although not shown in Fig. 1, an additional Bass (B) audio driver may also be employed which would allow a bass audio channel to be provided in order to furnish e.g., all 6 channels of a Dolby 5.1 audio system or the like.

Also, the exemplary audio output drivers 131-1 to 131-5 in Fig. 1 may represent e.g., pre-amplifiers in the pre-amplification stage or power amplifiers in the power amplification stage. In addition, the respective output level of the audio output drivers may be controlled by the processor 110 either through the control and data bus 125 or by varying the level(s) of the input(s) 119 to the audio output drivers 131-1 to 131-5. As shown in Fig. 1, the plurality of the audio outputs from the audio output drivers 131-1 to 131-5 are shown as being fed, directly or indirectly, to a plurality of respective speakers 140-1 to 140-5 in order to produce the corresponding sound from the audio source 115, after the sound has been further processed by processor 110, as to be described in more detail below.

According to the present principles, an exemplary detector 150 is provided and is configured to detect ambient sound in an exemplary location 105 as shown in Fig. 1. In one exemplary embodiment, the detector 150 may comprise a plurality of microphones, 150-1 to 150-5, with each microphone essentially being co-located in the proximate vicinity to each of the plurality of speakers 140-1 to 140-5 as shown in Fig.1. Accordingly, the microphones 150-1 to 150-5 may continually detect and sample the ambient sound in a passenger compartment of an automobile or in a home theatre room in an embodiment.

In another exemplary embodiment, the plurality of microphones 150-1 and 150-5 may be directional microphones which have directionality of detection in order to determine where a sound is coming from. Therefore, according to an exemplary aspect of the present principles, microphones 150-1 to 150-5 are able to provide detected sounds as inputs to processor 110 for further processing in order to determine whether a voice or a conversation is detected, as well as to determine the location of the origin and the direction of travel of such a detected voice or conversation. Accordingly, by employing multiple microphones in different parts of a location as shown in Fig. 1, the location of the origin and the direction of travel of the voice may be determined in the location 105, using e.g., known triangulation techniques.

According to another exemplary aspect of the present principles, the processor 110 performs the analysis of the detected sound samples inputted from the detector 150 described above in order to determine whether the ambient noise detected by the detector 150 includes a voice of a person or a conversation of people in the location. In another non-limiting embodiment, an exemplary DSP in processor 110 may be employed to make such a determination as is well known in the art. For example, in order to determine whether a human speech is present, known speech detection techniques may be used. These techniques in speech processing may involve first detecting whether sound is present in the range of the frequencies of a typical speech using a bandpass filter or filtering. The potentially detected voice may be further processed by speech recognition types of applications that provide different compromises between latency, sensitivity, accuracy and computational cost. Voice activity detection is usually language independent. Some algorithms also provide further analyses, for example, of whether the speech is voiced, unvoiced or sustained. Therefore, by employing a known voice detection algorithm, processor 110 is able to provide the determination that a voice of a person is present in the location 105.

Furthermore, processor 110 may first filter out the intended output sound from the audio source 115 in order to better analyze and determine whether the ambient sound detected by detector 105 contains a voice of a person and that the voice detected is not from the source material. As well known in the art, such a filtering may be accomplished using an echo canceller or an echo cancelling function implemented e.g., by the DSP of processor 110. Echo cancellation involves first recognizing the originally transmitted signal that appears at the output. Once the echo is recognized, it can be removed by subtracting it from received signal. Accordingly, the echo canceller or function also receives information from the detector 105. The originally transmitted signal is then removed from the signal received from the microphone 150-1 to 150-5 by the echo canceller or cancelling function performed by processor 110.

In another exemplary embodiment as shown in Fig. 1, the detector 105 may further comprise a camera 150-6 for aiding the determination of whether a voice of a human is present in the location 105. That is, the camera 150-6 may provide visual data to processor 110 for further analysis and processing. By using known image processing techniques, processor 110 is better able to determine whether a person or people are present in the location where the exemplary audio system 100 is located. The known image processing techniques may be used to determine, e.g., whether there is a movement in the location, and/or whether one or more human faces or silhouettes are detected by the camera 150-6. The presence of the camera 150-6 would therefore help the processor 110 to determine whether the detected ambient sound from microphones 150-1 to 150-5 actually contains a human voice which is not from the original audio source 115.

Therefore, according to the present principles, once processor 110 has determined that a voice or a conversation is present, and also has determined the location of the origin and/or the direction of travel of the voice as described above, the processor 110 is able to automatically adjust the sound level of one or more audio output drivers 131-1 to 131-5 of the audio system 100 shown in Fig. 1. In one embodiment, processor 110 is configured to enable a decrease in a level of at least one sound output of the plurality of sound outputs of one or more audio drivers 131-1 to 131-5, wherein the at least one sound output of the plurality of sound outputs being decreased is projecting sound in the direction toward the determined origin of the voice. For example, as shown in Fig. 1, if the audio system 100 determines that the detected voice 165 is originated from a person 160-1 and is from the direction of the sound projection of the speaker 140-1, processor 110 will cause the output level of the LF audio output driver 131-1 to be decreased. In accordance with another aspect of the present principles, an adjustment of the sound output level may comprise muting of the at least one sound output of the plurality of sound outputs projecting sound in the direction toward the determined origin of the voice. In a non-limiting exemplary embodiment of the present principles, processor 110 is further configured to maintain (i.e., not change) the levels of sound outputs of other of the plurality of sound outputs of the audio output drivers 131-2 to 131-5 whose sounds are not being projected in the direction toward the determined origin of the voice 165.

In another exemplary embodiment according to the present principles, however, the at least one sound output of the plurality of sound outputs projecting sound in the direction toward the determined origin of the voice, e.g., LF audio output driver 131-1, may be intentionally increased in order to make sure that the person 160-1 speaking does not miss the sound being outputted. This is especially useful and important when the sound is, e.g., a GPS directional instruction such as a turn instruction and/or an emergency announcement such as an amber alert, a tornado or a tsunami warning, and etc.

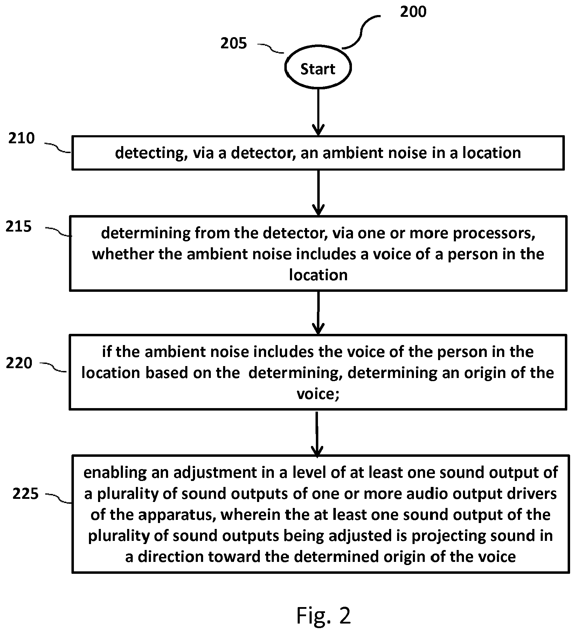

As shown in Fig. 1, audio system 100 also comprises a memory 112. Memory 112 may represent both a transitory memory such as RAM, and a non-transitory memory such as a ROM, a hard drive, a CD/DVD drive, a Blu-ray drive, and/or a flash memory. The non-transitory part of the memory 112 may be configured to store different files and information as necessary, including computer program products (e.g., as represented by a flow chart diagram of Fig. 2, as to be discussed below), user interface information, user profiles, metadata, electronic program listing information, databases, search engine software, and etc., as needed.

Fig. 2 represents a flow chart diagram of an exemplary process 200 according to the present principles. The exemplary process 200 may be implemented as a computer program product comprising computer executable instructions which may be executed by a processor or processors (e.g., processor 110 of the audio system 100 in Fig. 1). The computer program product having the computer-executable instructions may be stored in a non-transitory computer-readable storage medium as represented by e.g., memory 112 of Fig. 1, as described above. One skilled in the art can readily recognize that the exemplary process 200 may also be implemented using a combination of hardware and software (e.g., a firmware implementation), and/or executed using programmable logic arrays (PLA) or application-specific integrated circuit (ASIC), etc., as already mentioned above.

The exemplary process 200 in Fig. 2 starts at 205. At 210, the process detects, via a detector 105, an ambient noise in a location 105 as illustrated in Fig. 1. At 220, the process 200 determines, based on input(s) from the detector 105, via one or more processors (e.g., processor 110 in Fig. 1), whether the ambient noise includes a voice of a person in the location 105. At 220, if the ambient noise includes the voice (e.g., 165 in Fig. 1) of the person in the location 105 based on the determining at 215, process 200 further determines an origin of the voice. At step 225, process 200 enables an adjustment, e.g., a decrease, muting, or increase, in a level of at least one sound output of a plurality of sound outputs of one or more audio output drivers 131-1 to 131-5 of the apparatus 100, wherein the at least one sound output of the plurality of sound outputs being adjusted is projecting sound in a direction toward the determined origin of the voice, such as the LF audio output driver 131-1 shown in Fig. 1.

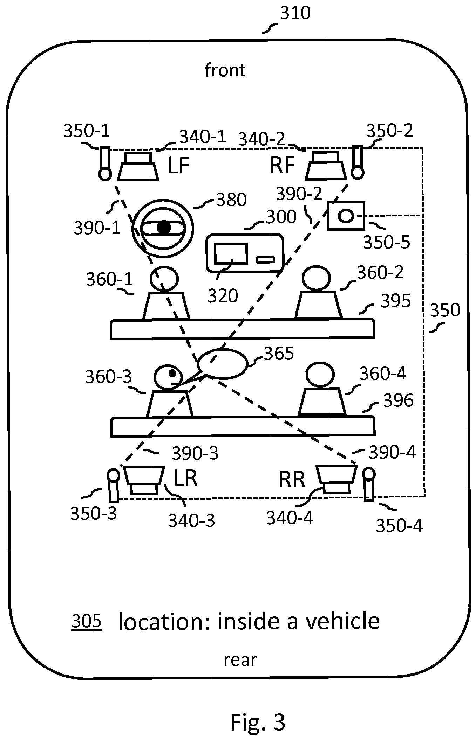

Fig. 3 illustrates another exemplary embodiment according to the present principles. The figure shows an exemplary audio apparatus 300 being deployed in a location 305 which is inside a vehicle such as an automobile 310. The front of the automobile 310 is indicate by the label "front", as well as being implied by where the steering wheel 380 is located. The exemplary audio apparatus 300 is shown in the front dash of the automobile 300, and may have e.g., a user interface touch display screen 320 for user interactions. The functions of user interface touch display screen 320 are similar to what have already been described for the user interface device 120 shown in Fig. 1. The exemplary audio apparatus 300 also has an ambient sound detector 350 which comprises of a plurality of four microphones 350-1 to 350-4, and a camera 350-5. The operations and functions of the microphones 350-1 to 350-4 and camera 350-5 of the detector 350 shown in Fig. 3 are also similar to those for the detector 150 as already described above in connection with Fig. 1.

In addition, Fig. 3 also shows that the car 310 has four audio speakers 340-1 to 340-4 for outputting and projecting four channels of audio outputs from the exemplary audio system 300. The four speakers 340-1 to 340-4 are, for example, located at left front, right front, left rear and right rear of the car, and each of the corresponding microphones 350-1 to 350-4 of the detector 350 are located near the respective speakers 340-1 to 340-4 as shown in Fig. 3.

Similar to what has already described in connection to Fig. 1 above, the detector 350 in Fig. 3 in conjunction of one or more processors (not shown) of the exemplary audio system 300 shown in Fig. 3 may determine the origin and the direction of travel of a detected voice in the car 310. For example, as shown in Fig. 3, a passenger 360-3 in the backseat 396 of the car 310 may be speaking toward another passenger 360-4 in the backseat 396. Accordingly, the voice 365 of the passenger 360-3 will be detected and the location of the origin of the voice and the direction of the travel of the voice may be determined. Based on the above determination, the level(s) of the sound output(s) to the one or more of the speakers 340-1 to 340-4 may be adjusted according to the present principles.

According to another exemplary embodiment of the present principles, the one or more processors of the exemplary audio system 300 of Fig. 3 may be configured to enable an adjustment such as a decrease or muting or increase in a level of at least one sound output of the plurality of the sound outputs of the one or more audio output drivers (not shown) of the audio system 300, so that the at least one sound output of the plurality of sound outputs being adjusted is projecting sound in a direction toward the determined origin of the voice. In the illustrated example of Fig. 3, the volume of the sound output of speaker 340-3 will be reduced in this case, since the voice 365 detected in Fig. 3 is in the direction of the projection of the speaker 340-3. In another non-limiting embodiment of the present principles, the one or more processors of the audio system 300 are further configured to maintain the levels of the sound outputs of the other speakers 340-1, 340-2, and 340-4.

In another embodiment, the direction of the travel of the voice 365 may be determined. As illustrated in Fig. 3, the person 360-3 is projecting his/her voice 365 toward the person 360-4 in the back seat of the car 396, in the left to the right direction. In that case, the exemplary audio system 300 may adjust, e.g., reduce, only the LR and RR speakers located in the backseat of the car 310 while maintaining the sound levels of the LF and RF speakers 340-1 and 340-2, since the direction of the travel of the detected voice is mainly limited to the backseat area 396 of the car 310.

According to another aspect of the present principles, the adjustment to the one or more sound outputs of the exemplary audio system 300 in Fig. 3 may be based on which sound output is located closest to the determined origin of the voice 365 shown in Fig. 3. As illustrated in Fig. 3, by measuring and comparing the respective distances 390-1 to 390-4 from each of the speakers 340-1 to 340-4 (as measured by each of the co-located microphones 350-1 to 350-4) to the detected voice 365, the output of the speaker 340-3 will be decreased, since it has the shortest distance 390-3 among the four distances determined. In another non-limiting exemplary embodiment, if the sound level adjustment comprises a decrease in sound level, the decrease for each of the four speakers 340-1 to 340-4 may be in an inverse proportion to determined respective distances 390-1 to 390-4 between the determined origin of the voice 365 to each of the respective sound outputs. That is, the level of the closest sound output will be reduced the most, and the level of the farthest sound output will be reduced the least.

Control of the sound output based on distance between a source of sound output, e.g., one of the speakers, and the origin of a voice may be combined with control based on level of sound output from each speaker. For example, first and second speakers may be located respective first and second distances from an origin of a voice. If the sound level adjustment comprises, for example, a decrease in sound level and both speakers are producing sound at the same or similar levels directed toward the origin of the voice and the first distance is greater than the second distance then a level of sound reduction at the first speaker responsive to detecting a voice may be less than a level of sound reduction at the second speaker. Another exemplary embodiment may comprise first and second speakers producing sound directed toward an origin of a voice and located respective first and second distances from the origin of the voice, wherein the first distance is greater than the second distance, and adjusting, e.g., decreasing or muting or increasing, sound produced by the second speaker while leaving the sound output from the first speaker unchanged based on the relative levels of sound output by each speaker, e.g., a level of sound output from the first speaker being less than a first value or a first threshold level and/or a level of sound output from the second speaker being greater than a second value or second threshold level.

Accordingly, the present principles provide exemplary audio systems, methods and computer program products which are able to automatically and intelligently adjust, such as, e.g., decrease, mute, or even increase the sound level or levels of the one or more audio outputs of an audio system based on the determined origin and/or direction of travel of a detected human voice inside a location.

While several embodiments have been described and illustrated herein, those of ordinary skill in the art will readily envision a variety of other means and/or structures for performing the functions and/or obtaining the results and/or one or more of the advantages described herein, and each of such variations and/or modifications is deemed to be within the scope of the present embodiments. More generally, those skilled in the art will readily appreciate that all parameters, dimensions, materials, and configurations described herein are meant to be exemplary and that the actual parameters, dimensions, materials, and/or configurations will depend upon the specific application or applications for which the teachings herein is/are used. Those skilled in the art will recognize, or be able to ascertain using no more than routine experimentation, many equivalents to the specific embodiments described herein. It is, therefore, to be understood that the foregoing embodiments are presented by way of example only and that, within the scope of the appended claims and equivalents thereof, the embodiments disclosed may be practiced otherwise than as specifically described and claimed. The present embodiments are directed to each individual feature, system, article, material and/or method described herein. In addition, any combination of two or more such features, systems, articles, materials and/or methods, if such features, systems, articles, materials and/or methods are not mutually inconsistent, is included within the scope of the present embodiment.

## Claims

1. Apparatus comprising:
a detector (150) configured to detect an ambient noise in a location (105);
one or more processors (110) configured to determine from the detector whether the ambient noise includes a voice of a person (160-1;160-2) in the location, and based on determining that the ambient noise includes the voice of the person in the location, further configured to determine an origin of the voice; and
the one or more processors are further configured to enable an adjustment in a level of at least one sound output of a plurality of sound outputs (140-1 ;140-2;140-3;140-4;140-5) of one or more audio output drivers (131-1;131-2;131-3;131-4;131-5), wherein the at least one sound output of the plurality of sound outputs being adjusted is projecting sound in a direction toward the determined origin of the voice.

2. The apparatus of claim 1 wherein the adjustment comprises one of a decrease, a muting, and an increase in the level of the at least one sound output of the plurality of sound outputs of the one or more audio drivers.

3. The apparatus of claim 1 or 2 wherein the one or more processors (110) are further configured to maintain a level of sound output of other of the plurality of sound outputs of the one or more audio output drivers not being projected in the direction toward the determined origin of the voice.

4. The apparatus of any one of claims 1, 2, or 3 wherein the detector (150) comprises a plurality of microphones (150-1,150-2,150-3,150-4,150-5), and the plurality of microphones are configured to provide one or more inputs to the one or more processors (110) for the determining whether the ambient noise includes a voice of a person in the location.

5. The apparatus of any one of claims 1 through 4 further comprising a camera (150-6) wherein the camera is further configured to provide one or more inputs to the one or more processors for the determining whether the ambient noise includes a voice of a person in the location, and wherein the camera is used to determine a presence of a human in the location.

6. The apparatus of any one of the preceding claims wherein the one or more processors is further configured to determine one or more of the plurality of sound outputs of the one or more audio output drivers located closest to the determined origin of the voice, and enable the adjustment in a sound level of the determined one or more of the plurality of sound outputs of the one or more audio output drivers located closest to the origin of the voice.

7. The apparatus of claim 6 wherein the at least one sound output of the plurality of sound outputs being adjusted is adjusted in an inverse proportion to a distance from the at least one sound output to the determined origin of the voice.

8. A method comprising:
detecting (210), via a detector, an ambient noise in a location;
determining (215) from the detector, via one or more processors, whether the ambient noise includes a voice of a person in the location;
if the ambient noise includes the voice of the person in the location based on the determining, determining (220) an origin of the voice; and
enabling (225) an adjustment in a level of at least one sound output of a plurality of sound outputs of one or more audio output drivers, wherein the at least one sound output of the plurality of sound outputs being adjusted is projecting sound in a direction toward the determined origin of the voice.

9. The method of claim 8 wherein enabling the adjustment comprises enabling one of a decrease, a muting, and an increase in the level of the at least one sound output of the plurality of sound outputs of the one or more audio drivers.

10. The method of claim 8 or 9 further comprising maintaining, via the one or more processors, a level of sound output of other of the plurality of sound outputs of the one or more audio output drivers not being projected in the direction toward the determined origin of the voice.

11. The method of any one of claims 8, 9, or 10 wherein the detector comprises a plurality of microphones, and the plurality of microphones are configured to provide one or more inputs to the one or more processors for the determining whether the ambient noise includes a voice of a person in the location.

12. The method of any one of claims 8 to 11 wherein determining whether the ambient noise includes a voice of a person in the location includes using a camera to determine a presence of a human in the location.

13. The method of any one of claims 8 to 12 further comprising determining, via the one or more processors, one or more of the plurality of sound outputs of the one or more audio output drivers located closest to the determined origin of the voice, and enabling, via the one or more processors, the adjustment in a sound level of the determined one or more of the plurality of sound outputs of the one or more audio output drivers located closest to the origin of the voice.

14. The method of claim 13 wherein the at least one sound output of the plurality of sound outputs being adjusted is adjusted in an inverse proportion to a distance from the at least one sound output to the determined origin of the voice.

15. A computer program product stored in a non-transitory computer-readable storage medium, comprising computer-executable instructions for performing the method of any one of claims 8 to 14.
